# EUROPEAN PATENT APPLICATION

(11) **EP 1 691 591 A1**
(43) Date of publication of application: **16.08.2006**
(21) Application number: 05100911.6
(22) Date of filing: 09.02.2005
(51) Int. Cl.: H05K 1/18, H05K 3/34

(54) **Circuit board having recesses for inserting electronic components**

(71) Applicant: OPTIMUM CARE INTERNATIONAL TECH INC., Neihu District, Taipei City 114 (TW)
(72) Inventor: Lien, Jefrey, Shihlin District, 111, Taipei City (TW)
(74) Representative: Benatov, Emil Gabriel

(57) **Abstract**

The present invention relates to the structural design of a circuit board (1) having deposit holes (2). The design is to allocate one or more deposit holes (2) that are either caved in or penetrate through the board at locations specified by the spatial layout, as well as to set step-like holes on a multilayer circuit board. On the panel surrounding the edge of the deposit holes, circuit contacts (3) are provided for connecting electronic components (4) (for example IC transistors, connectors, resistors, capacitors, or other circuit boards), such that when placed in deposit holes (2), they can be welded or fixed via the circuit contacts (3).

## Description

### FIELD OF THE INVENTION

The present invention is related to the design of a circuit board having deposit holes, specifically, to an improved design for a circuit board (card) structure that can be widely applied in various circuit boards (cards), such that electronic components can make the most effective use of the space.

### DESCRIPTION OF PRIOR ART

Current electronic related products have a design trend towards having features of light weight compactness and sophistication, for example, Personal Digital Assistant (PDA), mobile phone, notebook, language translator, handy drive, and MP3 player etc. The conventional way to construct the main portion of these abovementioned electronic products, i.e. the circuit board, is to design electronic circuits(printed circuits) on the circuit board surface, then arrange many electronic components(such as IC transistor, electric connector, resistor, capacitor, or light emitting diode) with specific function to be welded on the circuit board, so as to accomplish the specific design function of the circuit board (card). For example, we can use the circuit board(card) as a circuit board for electronic products such as display card, motherboard, network card, memory card, mobile phone, or language translator; or as a circuit board(card) for other function.

However, the abovementioned construction scheme for an electronic board only arranged electronic components on the selected surface of the circuit board, and conventional electronic components all have certain volume and height, such that the formation after assembling the circuit board card can not meet the needs of having features of light weight, thinness, and sophistication. In particular, given the growing trend in electronic product design on providing multifunction capability (for example, a mobile phone with digital filming and MP3 playing functions), one major obstacle that needs to be overcome by conventional schemes is the question that how to make the most effective use of the limited space available on a circuit board, so as to be able to design and mount various different types of electronic components needed to provide multifunction capability.

### SUMMARY OF THE INVENTION

The present invention mainly aims at providing a space efficient way of mounting electronic components onto various circuit boards (cards) through the design of deposit holes on circuit boards, reducing both the board's volume and its thickness, so as to achieve true delicateness.

With reference to the above objective, the present invention is to allocate one or more deposit holes that are either caved in or penetrate through the board at locations specified by the spatial layout, as well as to set step-like holes on a multilayer circuit board. Circuit contacts (such as printed circuits, etc.), thereby are provided on the panel, at places where the deposit holes are located, for connecting electronic components (for example IC transistors, connectors, resistors, capacitors, or other circuit boards), such that when placed in deposit holes, they can be welded or fixed via the circuit contacts, further reducing the board's (card's) volume and its thickness.

### BRIEF DESCRIPTION OF THE DRAWINGS

Fig. 1 is a schematic diagram showing the circuit board having deposit holes according to the present invention.
Fig. 2 is a schematic diagram outlining an application of the penetrating deposit holes according to the present invention.
Fig. 3 is a schematic diagram showing the step-like penetrating deposit holes according to the present invention.
Fig. 4 is a schematic diagram outlining an application of the step-like penetrating deposit holes according to the present invention.
Fig. 5 is a schematic diagram outlining an embodiment of the concave deposit holes according to the present invention.
Fig. 6 is a schematic diagram outlining an embodiment of the step-like concave deposit holes according to the present invention.
Fig. 7 is a schematic diagram showing the circuit contacts with perforations according to the present invention.

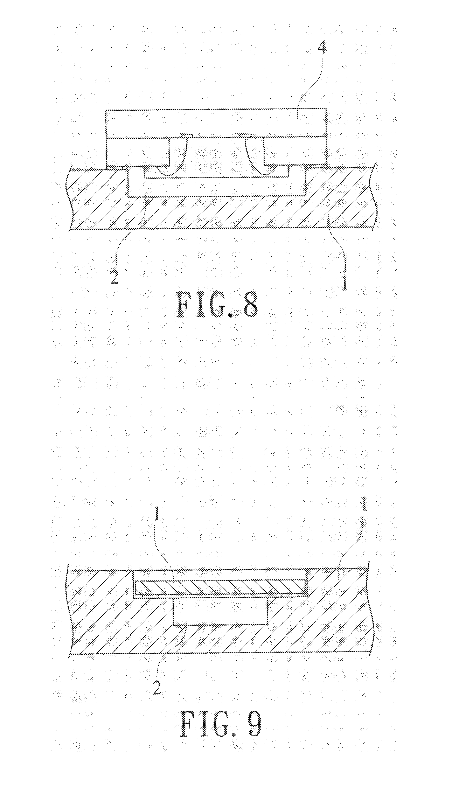

Fig. 8 is a schematic diagram outlining an embodiment of the concave deposit holes according to the present invention.
Fig. 9 is a schematic diagram outlining an embodiment of the step-like concave deposit holes according to the present invention.

### DETAILED DESCRIPTION OF THE PREFERRED EMBODIMENTS

Herein below, the structural features, embodiments, and objectives of the present invention are described in details with reference to the attached drawings:

As illustrated by the attached drawings, the present invention relates to the structural design of "circuit boards having deposit holes", wherein said circuit boards cover motherboards, display cards, memory cards, network cards, along with the circuit boards (cards) for mobile phones, translators, or other special purposes. The embodiments of the present invention include:

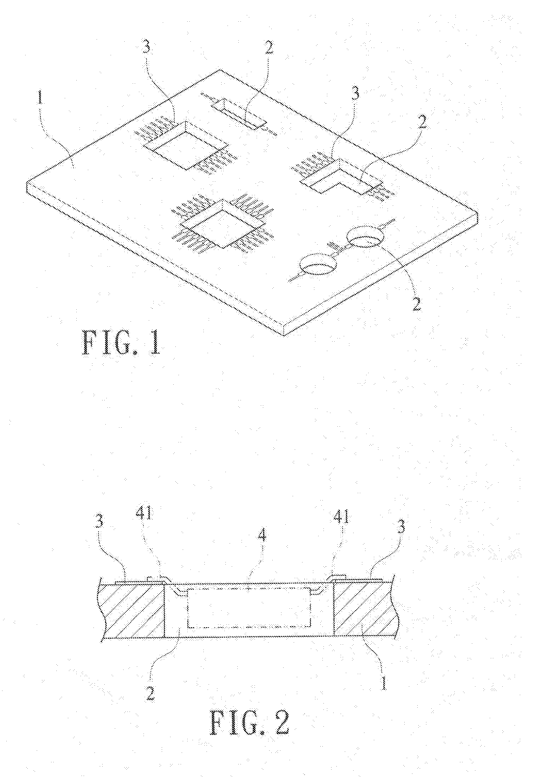

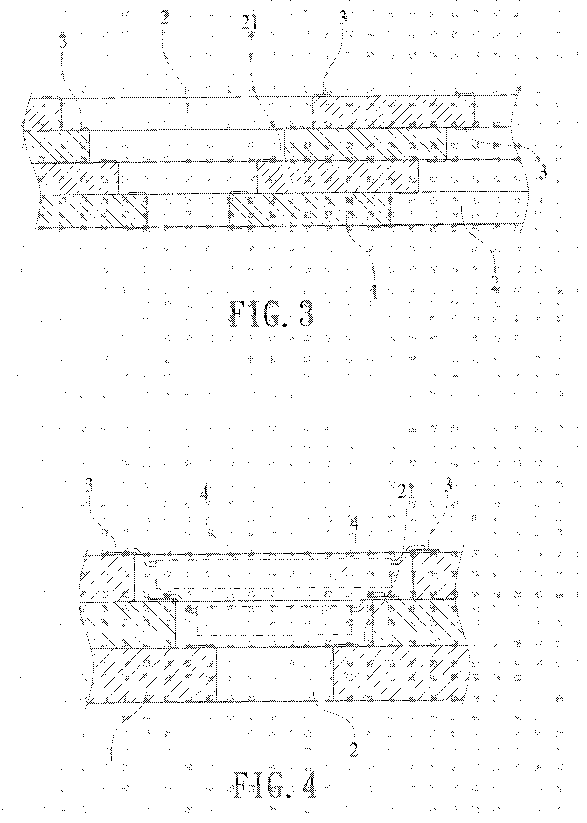

As shown in Fig. 1 and 2, one or more deposit holes 2 penetrate the circuit board 1 at locations specified by the layout of the final electronic device or circuit. Furthermore, the deposit holes 2 can either be designed with regular shapes, such as a rectangle or a circle, or shaped randomly. In addition, in accordance with the electronic components to be placed in the deposit holes 2, multiple circuit contacts 3 are fixed on one or both sides of the circuit board 1 along any one side or few sides of the edge of the deposit holes 2. In particular, this is how the circuit board having deposit holes of the present invention is structured, not only enabling one or more electronic components 4 (for example, electric devices like IC transistors, connectors, resistors, capacitors, or other circuit boards) to be put in the deposit holes 2, but also allowing their pins 41 to be fixed to said circuit contacts 3 either through welding or other methods. Another embodiment of the present invention is directed at multilayer printed circuit boards, as illustrated by Fig. 3 and 4, where deposit holes 2 are situated in a step-like geometry, and circuit contacts 3 can be found on a single or a number of step layers 21, thus leading to a circuit board with deposit holes 2 that can accommodate multilayers of multiple electronic components 4.

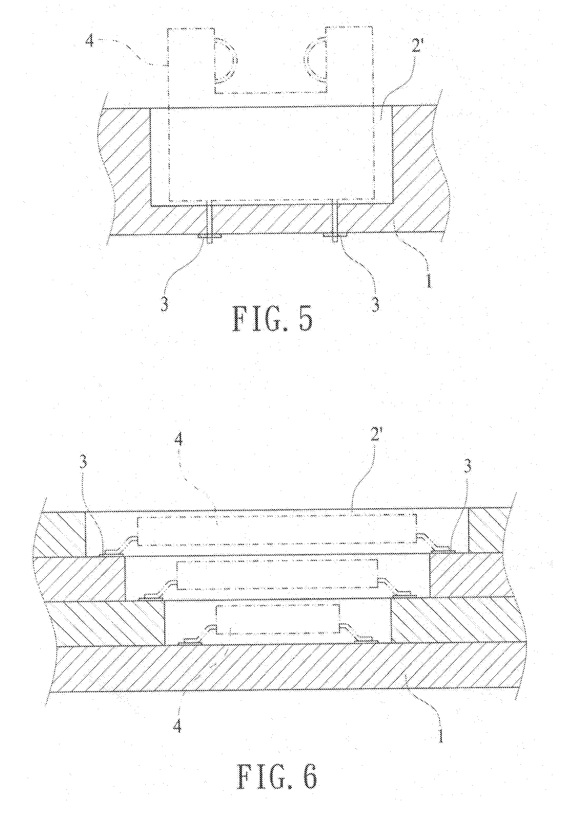

Secondly, instead of restricting to those that penetrate through the board, the embodiments of said deposit holes 2 also, as shown in Fig. 5, include concave deposit holes 2' on one or both sides of the circuit board 1, where said circuit contacts 3 are situated at the bottom, or on the surface along either any one side or multiple sides of the edge of the deposit holes 2'. This design, thereby, forms the circuit board having deposit holes of the present invention, allowing one or more electronic components 4 to be assembled via the concave deposit holes 4. Based on the same theory, this embodiment of the present invention of circuit boards having concave deposit holes 2' is also applicable to multilayer printed circuit boards, allocating one or more concave deposit holes 2' in a step-like geometry (as shown by Fig. 6), as well as circuit contacts 3 on a single or a number of step layers 21, thus resulting in a circuit board with deposit holes 2 that can accommodate multilayers of multiple electronic components 4.

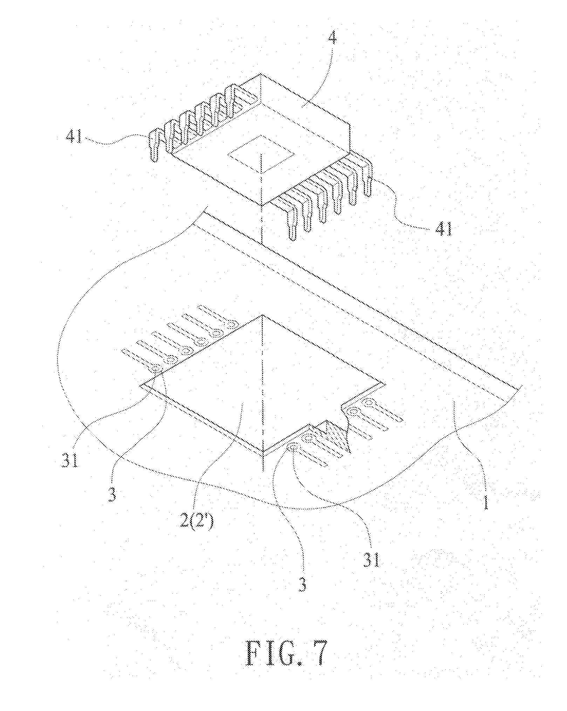

Another point to take into consideration is that circuit contacts 3 at locations where the deposit holes 2 and 2' of the present invention are located may be soldering points on common printed circuit boards. Therefore, without affecting their stated purpose of assembling electronic components 4, two types of circuit contacts 3 are employed; the ones with perforations 31 (as shown in Fig. 7) and those do not (as shown in the previous figures).

The present invention relates to the structural design of circuit boards having deposit holes 2, 2', through which electronic components 4 (for example, electric devices like IC transistors, connectors, resistors, capacitors, or other circuit boards) can be assembled once placed in them, thereby reducing the overall thickness of the circuit board 1. In addition, in order to avoid the common manifest side-by-side arrangement of circuit components, such components are mounted either side by side or on top of each other, such that as many as the necessary electronic components 4 can be fixed onto the limited circuit board space, thereby allowing the present invention to take further a dvantage of that space, reducing the volume and thickness of the circuit board (card), as well as enabling the final electronic device to achieve a better realization of the design goal for lightness, thinness, and delicateness. In summary, the structural design of "circuit boards having deposit holes" of the present invention has been proved to be both practicable and creative, with the invention's undoubtedly innovative embodiments combined with the perfect realization of the design goals through functionality, reasonable improvement is thus evidently traced. It is therefore decided to apply for an innovation patent according to related legal regulations. It is with great honor and sincere appreciation to have the esteemed patent bureau approve the present invention upon detailed review.

## Claims

1. A circuit board with deposit holes comprising: one or more penetrating deposit holes (2) located on the panel of the selected board, where multiple circuit contacts (3) are set on the circuit panel along at least one side of the deposit hole's edge, thereby forming a circuit board (1) where electronic components (4) can be placed in and fixed to the deposit holes (2).

2. The circuit board having deposit holes as set forth in claim 1, wherein, the deposit holes (2) could be replaced by concave holes 2' that do not penetrate through the board (1).

3. The circuit board having deposit holes as set forth in claim 1 or claim 2, wherein, the internal wall of the deposit holes (2) can be shaped in a step-like pattern with said multiple circuit contacts (3) provided on selected step layers (21).

4. The circuit board having deposit holes as set forth in claim 1 or claim 2, wherein, circuit contacts (3), with or without perforations (31), on the panel surface along the edge of the deposit holes (2') are to be welded to the pins (41) of electronic components (4).
